# EUROPEAN PATENT APPLICATION

(11) **EP 1 808 701 A1**
(43) Date of publication of application: **18.07.2007**
(21) Application number: 07000902.2
(22) Date of filing: 17.01.2007
(51) Int. Cl.: G01R 1/073, H01L 23/485, H05K 3/32

(54) **Test contact system**

(30) Priority: 17.01.2006 US 759459 P; 17.01.2007 US 623887 P
(71) Applicant: Sherry, Jeffrey C., Savage MN 55124 (US)
(72) Inventor: Sherry, Jeffrey C., Savage MN 55124 (US)
(74) Representative: Kirschner, Klaus Dieter

(57) **Abstract**

A test contact element (56,57,58) for making temporary electrical contact with a microcircuit terminal comprises at least one resilient finger (56a,56b,57a,57b) projecting from an insulating contact membrane (50) as a cantilevered beam. The finger has on a contact side thereof, a conducting contact pad for contacting the microcircuit terminal. Preferably the test contact element has a plurality of fingers, where each finger is defined at least in part by two radially oriented slots (62) in the membrane that mechanically separate each finger from every other finger of the plurality of fingers forming the test contact element. A plurality of the test contact elements can form a test contact element array (40) comprising with the test contact elements arranged in a predetermined pattern. A plurality of connection vias preferably in an interface membrane are arranged in substantially the predetermined pattern of the test contact elements, with each of said connection vias aligned with one of the test contact elements. The connection vias may have a cup shape with an open end, with the open end of the cup-shaped via contacting the aligned test contact element. The contact and interface membranes may be used as part of a test receptacle including a load board on which individual microcircuits are mounted for testing.

## Description

The invention pertains to improvements to equipment for testing microcircuits.

The manufacturing processes for microcircuits cannot guarantee that every microcircuit is fully functional. Dimensions of individual microcircuits are microscopic and process steps very complex, so small or subtle failures in a manufacturing process can often result in defective devices.

Mounting a defective microcircuit on a circuit board is relatively costly. Installation usually involves soldering the microcircuit onto the circuit board. Once mounted on a circuit board, removing a microcircuit is problematic because the very act of melting the solder for a second time ruins the circuit board. Thus, if the microcircuit is defective, the circuit board itself is probably ruined as well, meaning that the entire value added to the circuit board at that point is lost. For all these reasons, a microcircuit is usually tested before installation on a circuit board.

Each microcircuit must be tested in a way that identifies all defective devices, but yet does not improperly identify good devices as defective. Either kind of error, if frequent, adds substantial overall cost to the circuit board manufacturing process.

Microcircuit test equipment itself is quite complex. First of all, the test equipment must make accurate and low resistance temporary and non-destructive electrical contact with each of the closely spaced microcircuit contacts. Because of the small size of microcircuit contacts and the spacings between them, even small errors in making the contact will result in incorrect connections. Connections to the microcircuit that are misaligned or otherwise incorrect will cause the test equipment to identify the device under test (DUT) as defective, even though the reason for the failure is the defective electrical connection between the test equipment and the DUT rather than defects in the DUT itself.

A further problem in microcircuit test equipment arises in automated testing. Testing equipment may test 100 devices a minute, or even more. The sheer number of tests cause wear on the tester contacts making electrical connections to the microcircuit terminals during testing. This wear dislodges conductive debris from both the tester contacts and the DUT terminals that contaminates the testing equipment and the DUTs themselves.

The debris eventually results in poor electrical connections during testing and false indications that the DUT is defective. The debris adhering to the microcircuits may result in faulty assembly unless the debris is removed from the microcircuits. Removing debris adds cost and introduces another source of defects in the microcircuits themselves.

Other considerations exist as well. Inexpensive tester contacts that perform well are advantageous. Minimizing the time required to replace them is important too since test equipment is expensive. If the test equipment is off line for extended periods of normal maintenance, the cost of testing an individual microcircuit increases.

Test equipment in current use has an array of test contacts that mimic the pattern of the microcircuit terminal array. The array of test contacts is supported in a structure that precisely maintains the alignment of the contacts relative to each other. An alignment template or board aligns the microcircuit itself with the test contacts. The test contacts and the alignment board are mounted on a load board having conductive pads that make electrical connection to the test contacts. The load board pads are connected to circuit paths that carry the signals and power between the test equipment electronics and the test contacts.

"Kelvin" testing refers to a process where each microcircuit terminal contacts two test contacts. A preliminary part of the test procedure measures the resistance between the two test contacts. If this value is high, one or both of the two test contacts are not making good electrical contact to the microcircuit terminal. If the possibility of high resistance at this interface will affect the accuracy of the actual testing of the microcircuit performance, then the issue can be addressed according to the provisions of the testing protocol.

In the appended drawings, the form factors for the various components shown are not to scale where it may make it easier for the reader to understand the invention. Where relevant or helpful, the description includes representative dimensions.

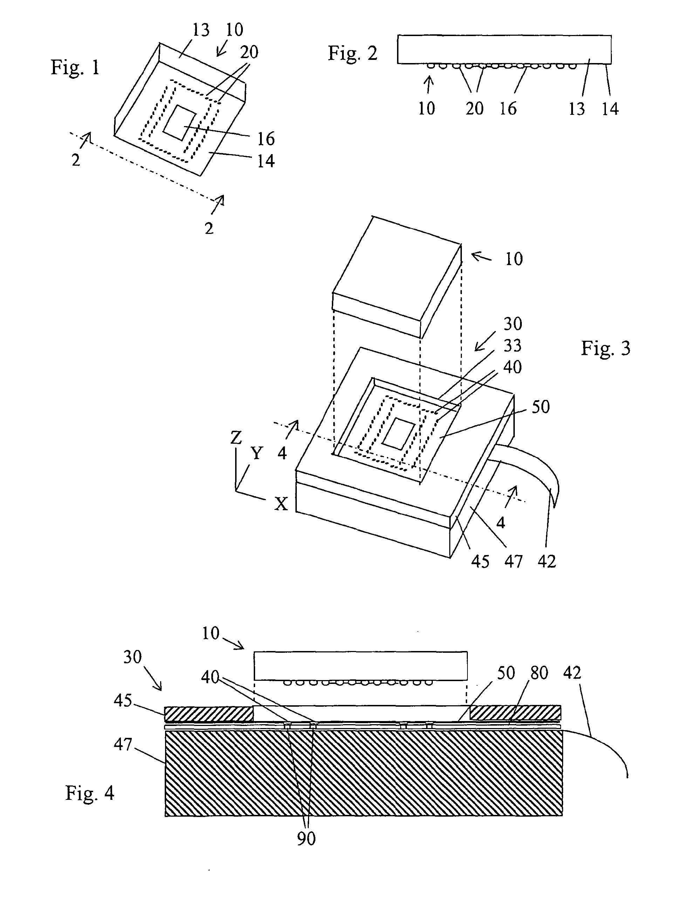

One particular type of microcircuit often tested before installation has a package or housing having what is commonly referred to as a ball grid array (BGA) terminal arrangement. Figs. 1 and 2 show an example of a BGA package type of microcircuit 10. Such a package may have the form of a flat rectangular block no on the order of 1.5 cm. on a side and 1 mm. thick.

Fig. 1 shows microcircuit 10 with a housing 13 enclosing the actual circuitry. Signal and power (S & P) terminals 20 are on one of the two larger, flat surfaces, surface 14, of housing 13. Signal and power (S&P) terminals 20 surround a projection 16 on surface 14. Typically, terminals 20 occupy most of the area between the surface 14 edges and spacer 16 rather than only a portion of the area as is shown in Fig. 1.

Fig. 2 shows an enlarged side or elevation view of terminals 20 as they appear with surface 14 on edge. Each of the terminals 20 comprise a small, approximately spherical solder ball that firmly adheres to a lead from the internal circuitry penetrating surface 14, hence the term "ball grid assembly." Fig. 2 shows each terminal 20 projecting a small distance further from surface 14 than does spacer 16. During assembly, all terminals 20 are simultaneously melted, and adhere to suitably located conductors previously formed on the circuit board.

Terminals 20 may be quite close to each other. Some have centerline spacings of as little as 0.5 mm., and even relatively widely spaced terminals 20 are still around 1.5 mm. apart. Spacing between adjacent terminals 20 is often referred to as "pitch."

In addition to the factors mentioned above, BGA microcircuit testing involves additional factors. In making the temporary contact with the ball terminals 20, the tester should not scratch or otherwise mark the S&P terminal surfaces that contact the circuit board, since such a mark may affect the reliability of the solder joint for that terminal.

Secondly, the testing process is more accurate if the length of the conductors carrying the signals is kept short. An ideal test contact arrangement has short signal paths.

Thirdly, solders commonly in use today for BGA terminals are mainly tin for environmental purposes. Tin-based solder alloys are likely to develop an oxide film on the outer surface that conducts poorly. Older solder alloys include substantial amounts of lead, which do not form oxide films. The test contacts must be able to penetrate the oxide film present.

BGA test contacts currently known and used in the art employ spring pins made up of multiple pieces including a spring, a body and top and bottom plungers.

The invention directed to a test contact system for testing integrated circuits with packages having an array of signal and power contacts.

A test contact element of the invention for making temporary electrical contact with a microcircuit terminal comprises at least one resilient finger projecting from an insulating contact membrane as a cantilevered beam. The finger has on a contact side thereof, a conducting contact pad for contacting the microcircuit terminal.

Preferably the test contact element has a plurality of fingers, which may advantageously have a pie-shaped arrangement. In such an arrangement, each finger is defined at least in part by two radially oriented slots in the membrane that mechanically separate each finger from every other finger of the plurality of fingers forming the test contact element.

A plurality of the test contact elements can form a test contact element array comprising the test contact elements arranged in a predetermined pattern. A plurality of connection vias are arranged in substantially the predetermined pattern of the test contacts elements, with each of said connection vias is aligned with one of the test contact elements. Preferably, an interface membrane supports the plurality of connection vias in the predetermined pattern.

The connection vias may have a cup shape with an open end, with the open end of the cup-shaped via contacting the aligned test contact element. Debris resulting from loading and unloading DUTs from the test equipment can fall through the test contact elements where the cup-shaped vias impound the debris.

The contact and interface membranes may be used as part of a test receptacle including a load board. The load board has a plurality of connection pads in substantially the predetermined pattern of the test contacts elements. The load board supports the interface membrane with each of the connection pads on the load board substantially aligned with one of the connection vias and in electrical contact therewith.

This invention uses a very thin conductive plate with retention properties that adheres to a very thin non-conductive insulator. The metal portion of the device provides multiple contact points or paths between the contacting I/O and the load board. This can be done either with a plated via hole housing or with plated through holes vias, or bumped surfaces, possibly in combination with springs, that has the first surface making contact with the second surface, i.e., the device I/O.

The present invention places the device I/O physically close to the load board, thus improving electrical performance. In addition the present invention also provides compliance thus allowing its use in both manual and automated test equipment.

The invention's structure provides a wiping function during testing on the sides of the ball terminals rather than the end that will contact the circuit board, while also providing very good electrical contact. The wiping function usually breaks through any oxide layers present on terminals 20. Each test contact has a hole in the middle of the contact surface, so the end of the terminal 20 is not marked during testing. This is particularly useful for lead-free terminals which tend to create thicker oxide layers. The vias that connect the test contact elements to the load board can be modified with springs to allow for microcircuit packages that do not have coplanar terminals and to provide Z axis compliance.

The invention is compatible with terminals 20 having fine pitch and could be easily used to interconnect to die or wafers. The concept has been successful for terminals with pitch from 1.27 mm. down to 0.5 mm. The non-conductive material holds the conductive portion of the design in place and aligns the package, die, and wafer I/O on any of the alternatives mentioned above.

Embodiments of the invention are now described with reference to the drawings in which:
Fig. 1 is a perspective view of a BGA microcircuit showing the terminals array;
Fig. 2 is an enlarged side elevation view of a BGA microcircuit;
Fig. 3 is a perspective view of a part of the test equipment having a DUT well for receiving the DUT for testing;
Fig. 4 is a side elevation cross section of the test equipment of Fig. 3;
Fig. 5 is a substantially enlarged top elevation view of a portion of a test contact array;
Fig. 6 is a side section view through the test contact array in exploded condition;
Fig. 7 is a side section view through the test contact array in assembled condition;
Fig. 8 is a side section view through the test contact array with ball terminals in test position on the test contacts;
Fig. 9 is a further enlarged top elevation view of a single test contact, and showing additional features of a preferred embodiment;
Fig. 10 is a perspective view of a test contact array;
Fig. 11 is a top elevation view of a complete, commercially usable interface membrane including alignment features;
Fig. 12 is a top elevation view of a complete, commercially usable contact membrane including alignment features;
Fig. 13 is a top elevation view of a complete, commercially usable spacer membrane including alignment features;
Fig. 14 is a perspective view of an alternative embodiment of the invention, using vias with internal springs; and
Fig. 15 is a top elevation view of a test contact showing the position of a spring biasing the test contact fingers.

Fig. 3 shows the general arrangement of a test receptacle 30 for a DUT comprising a BGA type microcircuit 10 of the type shown in Figs. 1 and 2. A load board 47 supports an alignment plate 45 having an opening or aperture 33 that precisely defines the X and Y (see the coordinate indicator) positioning of the microcircuit 10 in receptacle 30. If microcircuit 10 has orientation features, it is common practice to include cooperating features in aperture 33.

Load board 47 carries on its surface, connection pads connected to a cable 42 by S & P conductors. Cable 42 connects to the electronics that perform that electrical testing of microcircuit 10. Cable 42 may be very short or even internal to receptacle 30 if the test electronics are integrated with receptacle 30, or longer if the test electronics are on a separate chassis.

A test contact array 40 comprising a number of individual test contact elements precisely mirror the BGA terminals 20 carried on surface 14 of microcircuit 10. When microcircuit 10 is inserted in aperture 33, terminals 20 precisely align with test contact array 40. Receptacle 30 is designed for compatibility with a test contact array 40 incorporating the invention.

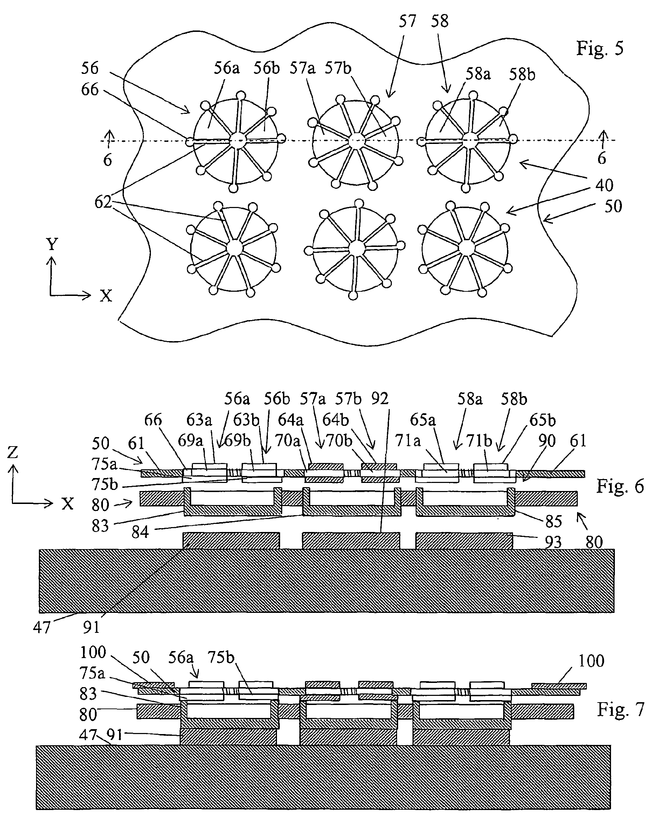

Test contact array 40 is carried on a contact membrane or sheet 50. Membrane 50 initially comprises an insulating plastic core layer 61 (see Fig. 6) such as Kapton (TM DuPont Corp.) with a layer of conductive copper on each surface. The Kapton layer and the copper layers may each be on the order of 0.001 in. thick. Individual test contacts in array 40 are preferably formed on and in membrane 50 using well-known photolithographic and laser machining processes.

Membrane 50 has alignment features such as holes or edge patterns located in the area between alignment plate 45 and load board 47 that provide for precise alignment of membrane 50 with corresponding projecting features on alignment plate 47. All of the test contacts 40 are in precise alignment with the membrane 50 alignment features. In this way, the test contacts of array 40 are placed in precise alignment with aperture 33.

The section view of Fig. 4 shows the general arrangement of test receptacle 30 with membrane 50 on edge, and with the section plane passing through some of the test contacts of array 40. The individual elements are slightly spaced in Fig. 4 so as to allow better understanding of the structure. When configured for use, the upper surface of membrane 50 contacts the lower surface of alignment plate 45, with all the elements of receptacle 30 held firmly together by machine screws or other fasteners.

The lower surface of membrane 50 mechanically contacts an interface membrane 80 of a special design. Membrane 80 has an array 90 of conductor vias. The ends of each via in array 90 extend slightly past the two surfaces of membrane 80 and are in precise alignment with test contacts 40. The term "via" here is used to denote a conductive column or post that extends completely through membrane 80 and is exposed on each side of membrane 80, although in this embodiment the term "pad" is perhaps more descriptive of the actual shape than is "column.". The vias that comprise array 90 and other features of membrane 80 are conventionally formed by well-known photolithographic processes.

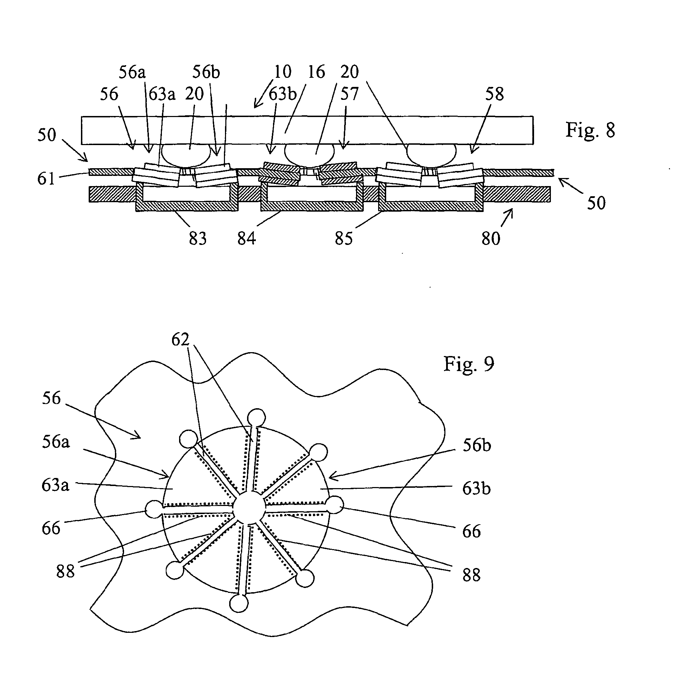

The vias comprising via array 90 have two main purposes. First, the vias of array 90 provide mechanical support and clearance space for operation of the array 40 test contacts. The vias of array 90 also electrically connect individual test contacts in array 40 to connection pads 91-93 (Figs. 6 and 7) on load board 47.

The structure of the test contact elements in array 40 is shown in Figs. 5-7. The Fig. 5 top projection shows three individual test contact elements 56 - 58 comprising a small portion of an array 40. Test contacts 56 **-** 58 display the detailed structure of all the individual test contact elements in array 40.

In one preferred embodiment, each of the test contacts 56 - 58 in array 40 comprise eight tapered fingers 56a, 56b, 57a, 57b, etc. generally configured in a pie shape. The outer ends of each of the fingers 56a, etc. are integral with layer 61 and generally form an arc of the same circle. The fingers 56a, etc. are mechanically and electrically isolated from each other by radially oriented slots 62 and other slots, undesignated. Laser machining is a convenient way to form slots 62. Portions of the initial layers of copper on layer 61 are removed to electrically isolate at least each of the test contacts 40 from each other. For Kelvin testing applications, some fingers 56a, etc. of a single test contact 56 can be electrically isolated from other fingers 56b, etc. as well.

Individual fingers 56a, etc. each subtend arcs of 45 ° for an eight finger embodiment. Other numbers of fingers 56a, etc. are well within the spirit of the invention. In fact, rectangular rather than pie-shaped fingers may well be suitable for DUTs that do not have a BGA configuration. To avoid bridges of membrane area between adjacent test contacts 56, etc. that are too thin, individual test contacts 56, etc. are rotated 22.5 ° with respect to each neighbor. This orientation spaces the ends of slots 62 in each of the test contacts 56, etc. as far as is possible from the slots 62 within the neighboring test contacts 56, etc.

Figs. 6 and 7 are side elevation sections through the slots 62 etc. that define the lower edges of fingers 56a, 56b, 58a, and 58b of test contacts 56 and 58. Note that the proportions between the dimensions are not to scale. This makes understanding of the invention easier. The section cut for Figs. 6 and 7 essentially bisects fingers 57a and 57b. One set of fingers 56a, etc. comprising one test contact 56, etc. Each of the fingers 56a, etc. is spaced from all of the other fingers of that test contact 40.

Each of the fingers 56a, etc. has a contact pad 63a, 63b, etc. facing in the positive Z direction. Pads 63a, 63b, etc. form for test contact 56, the surfaces that contact a terminal 20. Each finger 56a, etc. also has a connection pad 75a, 75b, etc. facing downwardly, in the negative Z direction. Contact pads 63a, 63b, etc. are in respective electrical contact with connection pads 75a, 75b, etc. This electrical connection can comprise plated edges 69a, 69b, 70a, 70b, 71 a, 71 b of fingers 56a, etc. as shown, or can comprise vias (not shown) that connect pads 63a, etc. to pads 75a, etc. through the inner layer 61 at a convenient point.

Each of the fingers 56a, etc. forms a cantilever beam that can elastically deflect out of the plane of membrane 50 by flexing layer 61 and, depending on the particular configuration, one or both of pads 63a, etc. and 75a, etc. comprising each of the fingers 56a, etc. To avoid stress concentration at the bases of the fingers 56a, etc., the bases of slots 62 may be wider than other points along slots 62. The bases of slots 62 that are wider may have the form of small circular openings or enlargements 66.

When in use, fingers 56a, etc. deflect downward, i.e. in the negative Z direction slightly. High stress concentration may result in permanent distortion of fingers 56a, etc. after repeated bending, which enlargements 66 at least partially alleviate. Enlargements 66 can be formed as part of the laser machining process that forms slots 62.

Interface membrane 80 is interposed between load board 47 and contact membrane 50. Membrane 80 may be somewhat thicker than membrane 50, since very little flexing of membrane 80 is required. The via array 90 in membrane 80 includes individual vias 83 - 85 having a cylindrical shape. Membrane 80 supports and positions the via array 90 as represented by vias 83 - 85, and places them in alignment with respectively, test contacts 56 - 58.

Load board 47 has connection pads 91 - 93 that connect using conventional technology to cable 42. Pads 91 - 93 are in precise alignment with the associated vias 83 - 85, thereby making solid electrical and mechanical contact with vias 83 - 85. This arrangement provides for extremely short conduction lengths between the BGA contacts 20 of a DUT 10 and the load board 47 connection pads 91 - 93.

Vias 83-85 can in one embodiment, comprise solid cylinders. However, a likely better configuration for them is the shape of a cup with open end up, as shown in Figs. 6 and 7. The edge of each via 83 - 85 contacts the adjacent connection pads 75a, etc. on fingers 69a, etc., and similar connection pads on the fingers of test contacts 57, 58, etc.

A number of reasons exist for this configuration of vias 83 - 85. In the first place, the structure allows each of the fingers 56a, etc. to flex freely downwards. Secondly, the cup-shaped structure of vias 83 - 85 is well-suited to collecting most of the inevitable debris that the testing process creates. As fingers 56a, etc. contact individual balls 20, debris that forms, falls through the fingers and is held within the vias 83 - 85. Protecting load board 47 from this debris prevents electrical performance from degrading and the load board 47 from mechanical damage.

Fig. 7 shows a portion of well 30 when assembled. Connection pads 75a, 75b, etc. are in firm electrical and mechanical connection with via 83. Note that the alignment plate 45 does not restrict flexing of individual fingers 56a, etc. The firm mechanical connection between connection pads 75a, etc. and via 83 minimizes the amount of debris that penetrates the contact area between connection pads 75a, etc. and via 83.

Fig. 8 shows the BGA terminals 20 of a DUT 10 in mechanical and electrical contact with the test contacts 56 - 58 as contacts 20 might be during an actual test procedure. Fingers 56a, etc. deflect elastically and independently into the interior spaces of vias 83 - 85 under force applied by a DUT loading element of the test equipment. If an individual BGA terminal 20 is in less than perfect alignment with its test contact 56 - 58, the independent compliance of each individual finger 56a, etc. assures that good electrical contact occurs between the test contact 56, etc. involved and the associated BGA terminal 20 throughout the test procedure.

A spacer 100 positions a DUT 10 properly in the Z axis position during loading, and prevents DUT 10 from pressing excessively on test contacts 65,etc.

The central area of each BGA terminal 20 does not touch any of the fingers 56a, etc. Accordingly, these central areas remain unmarked during the testing procedure.

The spaces formed by the slots 62 and the gap between the free ends of fingers 56a, etc. allow debris to fall through to the interior of vias 83 - 85. The cup configuration of each via 83- 85 traps the debris and prevents the debris from reaching load board 47 and mechanically damaging load board 47, which is an expensive component of the test equipment.

Fig. 9 is a further enlarged top elevation view of test contact 56 shows further features thereof. In particular, serrations or teeth 88 on the surfaces 63a, etc. of individual fingers 56a, etc., make contact with BGA terminals 20 during testing. Teeth 88 cut and scratch through any oxide layer on BGA terminals 20 while terminals 20 are pressed onto test contacts 56 etc. Teeth 88 may be positioned at any convenient place on the contact pads 63a, etc. Ideally, teeth 88 are in approximate radial alignment with the circle defining each of the test contacts 56, etc. This allows a cutting effect of teeth 88 on BGA terminal 20 surfaces while microcircuit 10 is loaded into receptacle 30 and BGA terminals 20 deflect fingers 56, etc.

The teeth 88 can be formed by a variety of techniques. A preferred technique is to form teeth 88 along the edges of fingers 56a as a serendipitous byproduct of the preferred laser machining process for forming slots 62. The use of relatively high laser beam intensity during the slot-forming process causes splashing and furrowing of the copper sheet carried by membrane 50. Ideally, the laser machining beam is directed onto the top surface of membrane 50. Often, the exposed copper surfaces of fingers 56a, etc. are plated with thin layers of nickel and gold. This plating process does not seem to interfere with the ability of teeth 88 to adequately cut into the surfaces of BGA terminals 20.

The following values are suitable for various dimensions of the components in a receptacle 30 designed for BGA terminals 20 having .8 mm. centers. All values are in mm. Approximate values for dimensions not specifically stated can be inferred from those given.

| | |
|---|---|
| Test contact 56 diameter | 0.5 |
| Slot 62 width | 0.03 |
| Layer 61 thickness | 0.025 |
| Pads 63a and 75a thickness | 0.018 |

The Z axis compliance of fingers 56a, etc. is a function of finger 56a, etc. length and thickness and I/O exposure allowing for multiple fields of contacting use.

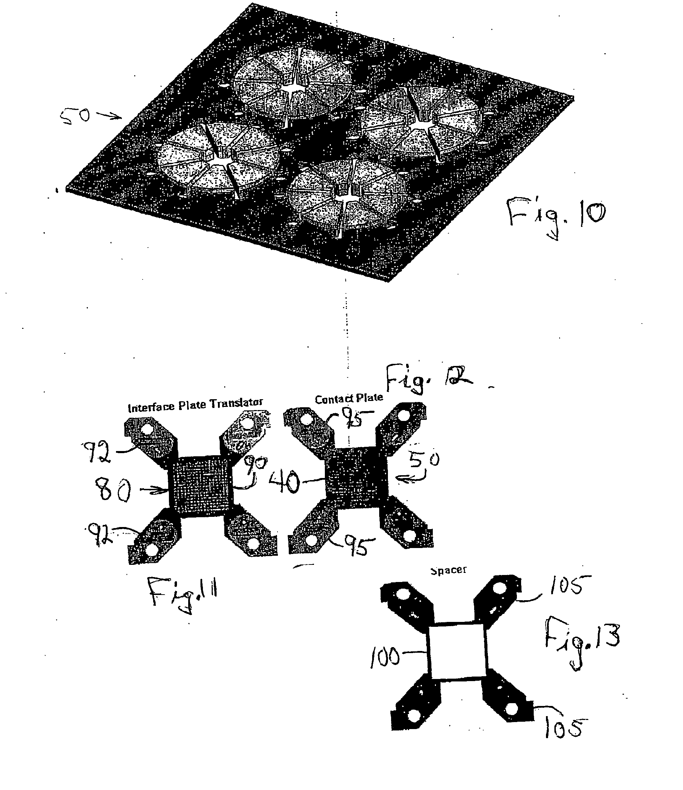

Fig. 10 is a perspective view of a portion of a contact membrane 50. One can see the individual contact pads 63a, etc. projecting slightly above the surrounding surface of membrane 50.

Fig. 11 is a top elevation view without enlargement, of an interface membrane 80 with a complete via array 90 and alignment features 92 for precisely positioning membrane 80 relative to alignment plate 45.

Fig. 12 is a top elevation view without enlargement, of a contact membrane 50 with a complete test contacts array 40 and alignment features 95 for precisely positioning membrane 50 relative to alignment plate 45.

The vias 83 - 85 rigidly contact load board 47, which reduces load board 47 wear, a problem with other test contact designs. The design has a signal path that is relatively short and has only one or two rigid parts, so contact resistance is lower and more consistent than for designs with more parts in the path. This feature also improves electrical performance during the test procedure. The presence of a hollow conductor for a via confines the E-fields. The design reduces the number of right angle connections, improving electrical performance and signal fidelity.

Fig. 13 shows the shape of the spacer 105 that limits Z travel of a DUT 10. Alignment features 105 position spacer 100 properly in the Z direction with respect to test contact array 40.

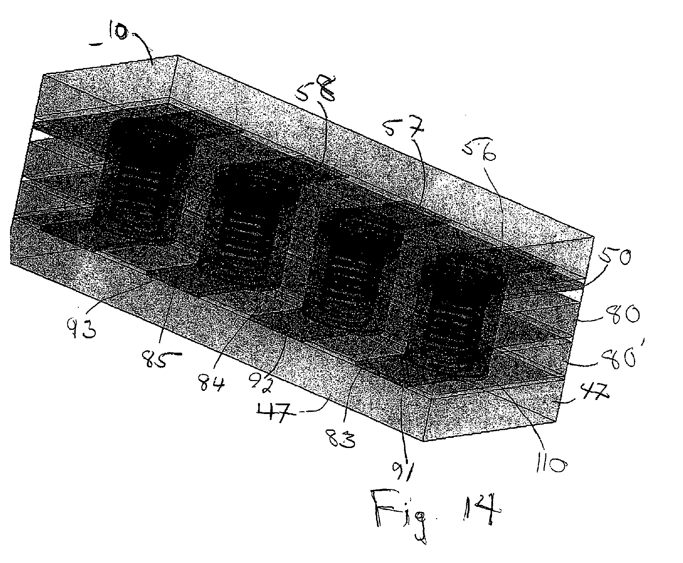

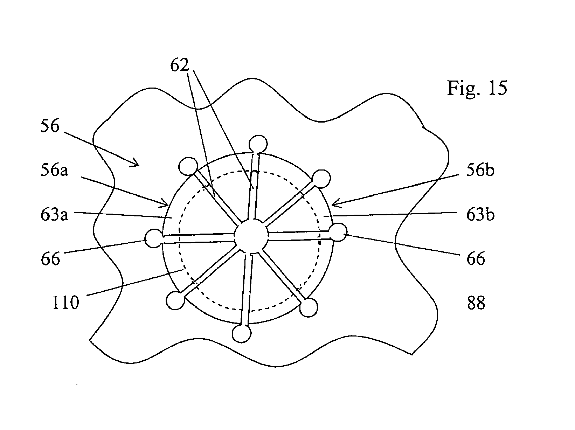

Figs. 14 and 15 show vias 83 - 85 configured with internal springs 110 that apply force at an intermediate points on fingers 56, etc. Fig.14 shows springs 110 interposed between the bottoms of the interior of vias 83 - 85 and individual fingers 56 - 58. The embodiment may in addition to interface membrane 80, require a second interface membrane 80'. The use of a spring 110 has the advantages of improved Z axis compliance, a further conduction path between fingers 56 - 58 and vias 83 - 85, and improved overall electrical performance.

The structure can be modified to allow Kelvin testing on a BGA or land device package. The Kelvin traces, if placed on circuit, could be routed to an interface where they are tied to a Kelvin measuring system without the need to modify boards using a connector to adapt to the Kelvin test system. The test contact 56 structure can be modified to electrically isolate half of the fingers 56a, etc. from the remaining fingers 56a, etc. Individual vias 83 - 85 can be divided to provide separate connections to the two sets of fingers 56a, etc. comprising each test contact 56, etc.

A slightly modified pad type can be used as a fiducial for optical handers that allow very accurate placement of the parts in the test contactor. The tolerances on the extra fiducial pad with a precision cut pattern would allow for optimum centering of the device on the contactor. The pad could be a distance from the device so the housing would need a small hole to allow the optics to align on the pad. Such a modification potentially will eliminate the need for alignment plate 45.

Alternatively, the design may include electrical isolation between each finger 56, etc. allowing higher thermal capability and reduced inductance of the path by doubling the number of paths from the top side to load board side. Electrically isolating each individual finger 56a, etc. from the other fingers of the test contact 56 may improve electrical performance.

The pads 63a, etc. can have many different sizes and shapes to match the device and/or device package I/O size, shape and pitch. Different thicknesses and strengths of layer 61; pads 63a, etc.; and 75a, etc. will provide different contact forces to the device I/Os. This feature allows contact force control to best penetrate different types and thicknesses of oxides, both of which range widely. Loaders are limited in the force they can provide. The ability to adjust the contact force allows for matching contact force to loader force.

A flexible insulating material is used to adjust the device resting point and optimize insertion forces. The spacer 100 thickness will be solely a function of the ball extension on the device or device package. By making the spacer out of the same material as the contact plate, real time compression adjustment occurs to account for contact pin stress relieving during operations at elevated insertion levels.

This design uses only two parts to interface both mechanically and electrically between a device and/or device package I/O and a load board during non-destructive device testing. A particular contact membrane 50 is potentially usable for a certain test application or can be a standard footprint for a family of devices with the same pitch. The interface membrane 80 may be a rigid circuit thick and stiff enough to assure the DUT I/O does not make destructive contact with load board 47. In this embodiment, an alignment plate fits on top and aligns the DUT to test contact array 40. Accordingly, multiple devices can be tested at the same time using minimum load board space. The rigid interface membrane 80 has conductor paths that route the signals directly to predetermined test points on the load board. In effect, the interface membrane 80 is specific to the DUT while the test contact array 40 is standardized.

This embodiment may have cost advantages since the test contact array 40 is more costly to manufacture than the interface membrane 80. This concept can be used to make contact to die on wafer and singulated die. The flexible interface on top can have embedded components that allow the test contactor system to simulate soldering a part to the printed circuit or load board. The flexible or membrane circuit on top is designed to have the following features:
1. Ability to make contact with device I/Os in an area that won't damage the I/O for future soldering.
2. Wipe function wipes through oxide layers on the I/O.
3. Slots in flexible circuit allow for user defined Z-compliance.
4. Slots is flexible circuit allow for multiple contact points to device to lower contact resistance and inductance.
5. Flexible circuit have matching or decoupling components embedded in the circuit and close to device inputs and outputs.
6. Pad pattern would be a function of device pitch, I/O size, and I/O extension so concept would be easily scalable with integrated circuit package ranges down to the pitch ranges on die.
7. The concept will work over military temperature range.
8. Ability to test multiple parts at the same time in small printed circuit board space will be optimum for production testing and burn-in testing.
9. Contact Plate could be shaped to the I/O geometry on device.
10. Solderless surface mount connection.
11. Semi-rigid contacts.
12. Ability to contact ball, pad or leaded terminals.
13. Multiple independent contacting of DUT terminals.
14. Self-centering feature and ability to optically align for increased precision.

The rigid board below would have the following features:
1. Route signals directly to load board with minimum distance.
2. interface with device under test inside cylinder to reduce EMI and crosstalk.
3. Custom signal routing is done to allow load boards to be reusable.
4. Provide a barrier between contact plate and expensive load board in case of part jamming or forces applied to contactor extremely high. If something is going to break, customer is going to want it to be the cheapest part of system.
5. Solderless surface mount.
6. Semi-rigid contacts.

This concept can be used in automated test environments without the need to screw in contactor or alignment plate to load board prior to testing. This makes the contactor easy to assemble and replace or clean. This would also allow for more precise alignment for smaller pitch devices.

Very low profile is employed so electrical performance is superior to any other BGA contactor or socket on the market. The contactor will have no wear on the load board and wipe the device in an area that will not affect its solder yet provide superior contact resistance. The concept will have multiple wipe points and redundancy in contacting the ball to reduce contact resistance and to reduce amount of openings even when some debris is present. The BGA interface could be used to facilitate self-alignment of the balls. Dimensions of the concept could easily be scaled to test very small devices with very small balls and even test bumped wafers, to be implemented as a concept, could be inverted to hit bumps on the wafer from the top. Designs can be developed so the contact plate can be rotated 180 degrees or reversed and still function properly. If devices are misaligned slightly, this feature could reduce the need for cleaning and increase potential life significantly.

The concept will determine when balls on the device are not present. The concept would work very well in applications that require large compliances such as strip testing. Debris generated from inserting the device into a test socket or contactor would fall through the hole in the interface membrane 80 to load board 47 and not affect testing. Intervals between maintenance required by debris buildup can thereby be lengthened. The flexible interface would be easy to replace and cost effective to throw away once its useful life expired. It only takes three minutes to rebuild, versus hours to rebuild a similar spring pin socket. The concept provides for the ability to use a flexible circuit to help in routing test signals to connectors on the edge of a board.

This Kelvin BGA concept is the first time anything has been developed to Kelvin test a BGA package. This is extremely valuable, as doing Kelvin on a BGA package would allow for external connection to a test system without making expensive modifications to the load board. Basically, a person using the invention would only use the Kelvin concept when he wanted to monitor the contact resistance to factor results into test software in order to allow a more accurate measurement and to extend the time between cleaning or maintenance cycles.

It will be understood that this disclosure, in many respects, is only illustrative. Changes may be made in details, particularly in matters of shape, size, material, and arrangement of parts without exceeding the scope of the invention. Accordingly, the scope of the invention is as defined in the language of the appended claims.

## Claims

1. A test contact element for making temporary electrical contact with a microcircuit terminal, comprising a resilient finger projecting from an insulating membrane as a cantilevered beam, and having on a contact side thereof, a conducting contact pad for contacting the microcircuit terminal.

2. The test contact element of claim 1, comprising a plurality of adjacent fingers, each projecting from an insulating membrane as a cantilevered beam, and each having on a contact side thereof, a conducting layer for contacting the microcircuit terminal.

3. The test contact element of claim 2, wherein each of the fingers forming the plurality of adjacent fingers are tapered and are configured in a pie shape.

4. The test contact element of claim 3, wherein a membrane supports the outer ends of the fingers.

5. The test contact element of claim 4, wherein the fingers are integral with the membrane.

6. The test contact element of claim 5, wherein each finger is defined at least in part by two slots in the membrane mechanically separating each finger from every other finger of the plurality of fingers forming the test contact element.

7. The test contact element of claim 6, wherein each slot is radially oriented.

8. The test contact element of claim 6, wherein at least one slot has an enlargement at the base thereof.

9. The test contact element of claim 6, wherein each finger has on the side of the finger opposite the contact side, a connection pad.

10. The test contact element of claim 9, wherein the contact pad and the connection pad on at least one of the individual fingers are electrically connected.

11. The test contact element of claim 10, wherein the at least one of the individual fingers has a conductive layer defining at least a part of the side of the adjacent slot, said conductive layer in electrical connection with the contact pad and the connection pad.

12. The test contact element of claim 6, wherein at least one finger has a number of teeth on the contact pad.

13. The test contact element of claim 12, with the teeth arranged in a linear pattern extending along at least one edge of the contact pad defined by a slot.

14. A test contact element array comprising a plurality of the test contact elements of any of the claims 1 to 13 arranging in a predetermined pattern.

15. The array of claim 14, wherein the slots defining the fingers of adjacent test contact elements have different angular orientations.

16. A test receptacle comprising
a) the test contact element array of claim 14 or 15; and
b) a plurality of connection vias arranged in substantially the predetermined pattern of the test contacts elements, each of said connection vias is aligned with one of the test contact elements.

17. The test receptacle of claim 16, including an interface membrane supporting the plurality of connection vias.

18. The test receptacle of claim 17, wherein at least one of the connection vias is cup-shaped with an open end, with the open end of the cup-shaped via contacting the aligned test contact element.

19. The test receptacle of claim 18, including a load board having a plurality of connection pads in substantially the predetermined pattern of the test contacts elements, said load board supporting the interface membrane with each of the connection pads substantially aligned with one of the connection vias and in electrical contact therewith.

20. The test receptacle of claim 16, including in a via, an internal spring pressing against at least one of the fingers of the test contact.
